# EUROPÄISCHE PATENTSCHRIFT

(11) **EP 1 094 513 B1**
(45) Veröffentlichungstag und Bekanntmachung des Hinweises auf die Patenterteilung: **21.12.2005**
(21) Anmeldenummer: 00120835.4
(22) Anmeldetag: 23.09.2000
(51) Int. Cl.: H01L 21/68, H01L 21/00

(54) **Methode zum Aufarbeiten von elektrostatischen Haltevorrichtungen**
Method to refurbish electrostatic chucks
Procédé de retraitement de mandrins électrostatiques

(30) Priorität: 29.09.1999 DE 19946645
(43) Veröffentlichungstag der Anmeldung: 25.04.2001
(73) Patentinhaber: VenTec - Gesellschaft für Venturekapital und Unternehmensberatung mbH, 57078 Siegen (DE)
(72) Erfinder: Arlt, Joachim, Dr., 57250 Netphen (DE)
(74) Vertreter: Maxton Langmaack & Partner

(56) Entgegenhaltungen:
- US-A- 5 463 526
- US-A- 5 634 978
- PATENT ABSTRACTS OF JAPAN vol. 1999, no. 09, 30. Juli 1999 (1999-07-30) & JP 11 111682 A (SONY CORP), 23. April 1999 (1999-04-23)

## Beschreibung

Elektrostatische Haltevorrichtungen, sog. E-Chucks, sind inzwischen Standardvorrichtungen zum Halten von Wafern in Anlagen zum Bearbeiten von Wafern. Auch wenn der Anteil von keramischen E-Chucks stetig zunimmt, so bestehen doch die allermeisten E-Chucks aus einem Grundkörper (Pedestal), auf den das eigentliche elektrostatische Haltesystem, bestehend aus einem Leiter zwischen Kunststoffolien, aufgeklebt ist. Dieses Foliensystem begrenzt die Lebensdauer des E-Chucks. Der Preis des E-Chucks wird aber im wesentlichen durch den Fertigungsaufwand für das Pedestal bestimmt. Daher ist es kostenmäßig interessant, das verbrauchte Foliensystem von dem Pedestal zu entfernen und durch ein neues zu ersetzen.

Aus US-A-5 463 526 ist bekannt, daß die obere dielektrische Schicht leicht durch Partikel und Kratzer beim Hantieren beschädigt werden kann. Ein direkter Kontakt zwischen Wafer und der Elektrode durch diese Löcher oder Kratzer kann zur Beschädigung des Wafers und/oder der Anlage führen. Dieses kann den Ersatz.oder die Reparatur dieser Chucks zur Folge haben.

Die den Leiter (in der Regel aus Kupfer) nach oben und unten isolierenden Folien werden fast immer aus Polyimid gefertigt und mit oder ohne Kleber nach bekannten Verfahren mit dem Kupfer verbunden. Die dem Pedestal zugewandte Folie des elektrostatischen Haltesystems wird auf das Pedestal aufgeklebt. Es kommen im wesentlichen heiß- und kaltaushärtende Kleber auf Epoxid-, Acryl-, Nitril-, Kautschuk- und Polyesterbasis alleine oder in Kombination zum Einsatz.

Diese Kleber stellen duroplastische Systeme dar und sind weder in polaren noch unpolaren Lösungsmitteln löslich.

Aus der Entlackungstechnik ist bekannt, daß solche duroplastischen Systeme thermisch entfernt werden können. Die dabei notwendigen Temperaturen würden jedoch zur Zerstörung des Pedestals führen.

Aus der Leiterplattenindustrie ist bekannt, daß Acryl- und Epoxidkleber sowie Lacke mit heißer konzentrierter Chromsäure entfernt werden können. Dies führt aber auch zur Zerstörung der Pedestals, da diese meistens aus anodisiertem Aluminium bestehen.

Nachdem in der Leiterplattenindustrie die Verwendung von Chromsäure aus Umweltgründen eingeschränkt worden ist, wurden Epoxide in einer heißen Mischung aus einem polaren organischen Lösemittel, zum Beispiel Butanol oder Butylglykol mit Kaliumhydroxid aufgelöst. Diese Mischung zerstört jedoch auch Aluminium und besonders Anodisierungen.

Auch wenn der Reaktionsmechanismus dieser vorgenannten "Stripper" nicht genau geklärt ist, wird angenommen, daß der Duroplast in dem polaren Solvenz stark quillt und dann alkalisch abgebaut wird. Ausgehend von dieser Beobachtung wurde die folgende Methode entwickelt, das Foliensystem von E-Chucks zu entfernen, ohne das Pedestal zu beschädigen.

Nach umfangreichen Versuchen hat sich das folgende Verfahren als besonders günstig herausgestellt. In einer ersten Stufe wird der komplette E-Chuck in ein polares organisches Lösemittel (z.B. Essigester, Butylglykol oder Aceton) 24 bis 48 Stunden lang eingelegt. Dabei quellen die Polyimidfolie und der Kleber so stark auf, daß das Foliensystem leicht abgezogen werden kann. In einer weiteren Stufe wird das Pedestal mit dem anhaftenden Kleber weitere 24 Stunden in das Lösemittel getaucht. Dabei quillt der Kleber weiter. Er kann jetzt mit einem Schaber weitestgehend abgestreift werden. Häufig ist die vorher kleberbehaftete Oberfläche jetzt schon ausreichend sauber.

Zur restlosen Entfernung des alten Klebers erweist sich eine warme (30°C bis 90°C) Mischung aus einem hochsiedenden polaren Lösemittel, zum Beispiel Butanol oder Monobutylglykol mit einem langkettigen Amin, als vorteilhaft. Eine typische Mischung ist 2,5% Tributylamin in Monobutylglykol. Je nachdem wie stark der Kleber vorgequollen ist, nach Typ des Klebers und seiner Schichtstärke werden Reaktionszeiten von 1 bis 15 Minuten benötigt. Das Ablösen des Klebers wird durch vorsichtiges Reiben mit einem anorganischen Vlies (z.B. Scotch Brite ®) gefördert.

Anschließend werden Reste der Reaktionslösung durch Spülen erst in einem niederviskosen polaren Lösemittel (z.B. Aceton, Isopropanol oder Essigester) und dann in deionisiertem Wasser, eventuell mit Ultraschallunterstützung, entfernt. Anschließend müssen die Bauteile sorgfältig, zum Beispiel durch 12-stündiges Ausheizen bei Normaldruck bei 150°C oder besser 12 Stunden im Vakuum (z.B. 100°C; 1 x 10⁻² mbar) von Lösemittelresten befreit werden.

Anschließend wird ein neues Foliensystem aufgeklebt und das elektrostatische Haltesystem so in einen neuwertigen Zustand versetzt. Wenn wie in den meisten Fällen das Pedestal beim Einsatz nicht zerstört wird, kann es mehrfach wieder verwendet werden und so eine signifikante Kostenersparnis erreicht werden.

## Patentansprüche

1. Verfahren zum Ablösen des Foliensystems von einem elektrostatischen Haltesystem, bestehend aus einem Grundkörper, wie einem Pedestal, und einem darauf aufgeklebten eigentlichen elektrostatischen Haltesystem, wiederum bestehend aus einer unteren auf das Pedestal aufgeklebten Folie, einem Leiter und einer oberen Abdeckfolie, **gekennzeichnet durch** folgenden Verfahrensschritt:
In einer ersten Stufe wird das komplette Haltesystem oder E-Chuck in ein polares organisches Lösemittel, zum Beispiel Essigester, Butylglykol oder Aceton, 24 bis 48 Stunden lang eingelegt, wobei die Polyimidfolie und der Kleber so stark aufquellen, dass das Foliensystem leicht abgezogen werden kann.

2. Verfahren nach Anspruch 1, **dadurch gekennzeichnet, dass**
in einer weiteren Stufe der vorgequollene Kleber ohne Gefahr von Beschädigungen des Pedestals durch das Lösemittel ganz und/oder verbleibende Reste mechanisch entfernt werden.

3. Verfahren nach Anspruch 1 oder 2, **dadurch gekennzeichnet, dass** der Kleber in einer 30°C bis 90°C heißen Mischung aus einem hochsiedenden polaren organischen Lösemittel mit 0,2% bis 10% eines Amins vollständig entfernt wird.

4. Verfahren nach der Ansprüche 1 bis 3, **dadurch gekennzeichnet, dass** die hochsiedenden Lösemittel erst mit niedersiedenden Lösemitteln und dann durch Trocknen im Vakuum entfernt werden.

5. Verfahren nach einem der Ansprüche 1 bis 4, **dadurch gekennzeichnet, dass** das Pedestal durch Aufkleben eines neuen Foliensystems zu einem neuwertigen elektrostatischen Haltesystem wird.

## Claims

1. A method for detaching the film system from an electrostatic holding system, consisting of a basic body such as a pedestal and an actual electrostatic holding system glued thereto, which in turn consists of a lower film glued to the pedestal, a conductor and an upper backing film, **characterised by** the following method step:
in a first stage, the complete holding system, or E-chuck, is placed in a polar organic solvent, for example ethyl acetate, butyl glycol or acetone, for 24 to 48 hours, whereupon the polyimide film and the adhesive swell to such an extent that the film system can be readily pulled off.

2. A method according to Claim 1, **characterised in that** in a further stage, the pre-swelled adhesive is removed entirely and/or any remnants are mechanically removed without the risk of damage to the pedestal by the solvent.

3. A method according to Claim 1 or 2, **characterised in that** the adhesive is completely removed in a mixture, at a temperature of 30°C to 90°C, of a high-boiling polar organic solvent with 0.2% to 10% of an amine.

4. A method according to one of Claims 1 to 3, **characterised in that** the high-boiling polar solvents are removed first with low-boiling solvents and then by drying in a vacuum.

5. A method according to one of Claims 1 to 4, **characterised in that** the pedestal is made into an "as-new" electrostatic holding system by gluing on a new film system.

## Revendications

1. Procédé de détachement du système de feuilles d'un système de maintien électrostatique, constitué d'un corps de base comme un socle et d'un système de maintien électrostatique proprement dit, qui y est collé, constitué à nouveau d'une feuille inférieure collée sur le socle, d'un conducteur et d'une feuille supérieure de finition, **caractérisé par** les stade de procédé suivant :
dans un premier stade, on met, pendant 24 à 48 heures, le système complet de maintien ou E-chuck dans un solvant organique polaire, par exemple dans de l'ester de l'acide acétique, du butylglycol ou de l'acétone, la feuille de polyimide et la colle gonflant si fortement que l'on peut retirer facilement le système de feuille, et

2. Procédé suivant la revendication 1, **caractérisé en ce que** dans un autre stade, on élimine complètement par le solvant la colle gonflée au préalable sans danger d'endommagement du socle et/ou on élimine mécaniquement des résidus qui subsistent.

3. Procédé suivant la revendication 1 ou 2, **caractérisé en ce que** l'on élimine complètement la colle dans un mélange chaud d'une température de 30° C à 90° C, constitué d'un solvant organique polaire à haut point d'ébullition ayant de 0,2 % à 10 % d'une amine.

4. Procédé suivant l'une des revendications 1 à 3, **caractérisé en ce que** l'on élimine les solvants polaires à haut point d'ébullition, d'abord par des solvants à bas point d'ébullition et ensuite par séchage sous vide.

5. Procédé suivant l'une des revendications 1 à 4, **caractérisé en ce que** le socle devient, par collage d'un nouveau système de feuilles, un système de maintien électrostatique à l'état neuf.
